(19) Europäisches Patentamt
European Patent Office
Office européen des brevets

(11) **EP 4 404 713 A2**

(12) **EUROPEAN PATENT APPLICATION**

(43) Date of publication:
**24.07.2024 Bulletin 2024/30**

(21) Application number: **24152091.5**

(22) Date of filing: **16.01.2024**

(51) International Patent Classification (IPC):
**H10K 50/19** $^{(2023.01)}$    **H10K 59/80** $^{(2023.01)}$

(52) Cooperative Patent Classification (CPC):
**H10K 59/876; H10K 50/19**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **17.01.2023 JP 2023005207**

(71) Applicant: **CANON KABUSHIKI KAISHA**
**Tokyo 146-8501 (JP)**

(72) Inventors:
• **SANO, Hiroaki**
  **Tokyo (JP)**
• **MATSUDA, Yojiro**
  **Tokyo (JP)**
• **ITO, Takayuki**
  **Tokyo (JP)**

(74) Representative: **WESER & Kollegen**
**Patentanwälte PartmbB**
**Radeckestraße 43**
**81245 München (DE)**

(54) **LIGHT EMITTING ELEMENT**

(57)    A light emitting element includes a first element having (100a) a first lower electrode (102a), a first light emitting layer (105a) for emitting light of a first color, a charge generation layer (107), a second light emitting layer (109a) for emitting light of the first color, and an upper electrode (111) in this order on a substrate (101). A space (A)between the first light emitting layer (105a) and the first lower electrode (102a) is larger than a space (B) between the first light emitting layer (105a) and the second light emitting layer (109a).

FIG. 1

**Description**

BACKGROUND OF THE INVENTION

Field of the Invention

The technology of the present disclosure relates to a light emitting element.

Description of the Related Art

An organic light emitting element (which is also referred to as an organic electroluminescence element (an organic EL element)) is an electronic element having a pair of electrodes and an organic compound layer arranged between the electrodes. Injection of electrons and holes from a pair of electrodes generates excitons of a luminous organic compound in an organic compound layer. When the exciton returns to the ground state, the organic light emitting element emits light. The recent progress of the organic light emitting element is remarkable, so that low driving voltage, various light-emitting wavelengths, high-speed response, thickness reduction / weight reduction of a light-emitting device have been promoted.

As the technology of implementing the higher efficiency of the organic light emitting element, there is known a method for depositing an organic layer for each color using a metal mask, photolithography, and the like (which will be hereinafter referred to as a differently coating method).

On the other hand, a tandem type organic light emitting element is known in which a charge generation layer is provided between a plurality of light emitting layers in order to improve the power consumption of the organic light emitting element. Application of an electric field between a lower electrode and an upper electrode generates carriers at the charge generation layer. Accordingly, the carriers are supplied to each light emitting unit. For this reason, it is possible to cause the light emitting layer included in each light emitting unit to emit light with efficiency.

U.S. Patent Application Publication No. 2015/0188087 describes an organic light emitting element including a light emitting layer deposited therein by the differently coating method. U.S. Patent Application Publication No. 2015/0188087 describes an organic light emitting element having a first light emitting unit and a second light emitting unit between a first electrode and a second electrode, and having an electric charge generation layer between the light emitting units. Further, in U.S. Patent Application Publication No. 2015/0188087, by setting the thickness of the layer between the light emitting layer of the first light emitting unit and the light emitting layer of the second light emitting unit larger than the thickness of the space between the first light emitting layer and the first electrode, it is possible to enhance the luminous efficiency due to the microcavity effect.

In recent years, an organic light emitting element has been also used for a display panel for Augmented Reality (which will be hereinafter referred to as an AR panel). For the AR panel, a panel with a more intense directivity of the emitted light is preferable. In order to enhance the directivity of the light emitted by the organic light emitting element, a larger order of interference of the microcavity structure for use in an organic light emitting element is better.

However, it was found as follows: with the organic light emitting element of U.S. Patent Application Publication No. 2015/0188087, when the order of interference is large, the relationship does not hold in which the space between the light emitting layer of the first light emitting unit and the light emitting layer of the second light emitting unit becomes larger than the space between the first light emitting layer and the first electrode.

SUMMARY OF THE INVENTION

The technology of the present disclosure was completed in view of the foregoing problem, and provides a light emitting element with a higher directivity of the emitted light while enhancing the luminous efficiency due to the microcavity structure.

According to some embodiments, it is provided a light emitting element as specified in claims 1 to 12. In addition, it is provided a display apparatus as specified in claim 13, a photoelectric conversion device as specified in claim 14, electronic equipment as specified in claim 15, a lighting apparatus as specified in claim 16, and a mobile body as specified in claim 17.

Further features of the present invention will become apparent from the following description of exemplary embodiments with reference to the attached drawings.

BRIEF DESCRIPTION OF THE DRAWINGS

FIG. 1 is a view schematically showing a structure of a light emitting element in accordance with a first embodiment;
FIG. 2 is a view schematically showing a structure of a light emitting element in accordance with a second embodiment;
FIG. 3 is a view schematically showing a structure of a light emitting element in accordance with a third embodiment;
FIG. 4 is a view schematically showing a structure of the light emitting element in accordance with the third embodiment;
FIG. 5 is a view schematically showing a structure of a light emitting element in accordance with a fourth embodiment;
FIG. 6 is a view schematically showing a structure of the light emitting element in accordance with the fourth embodiment;
FIG. 7 is a view schematically showing a structure of a light emitting element in accordance with a fifth embodiment;
FIG. 8 is a view schematically showing a structure of another light emitting element in accordance with the first embodiment;
FIG. 9 is a view showing one example of a display apparatus in accordance with one embodiment;
FIGS. 10A and 10B are each a view showing one example of an image pickup apparatus and electronic equipment in accordance with one embodiment;
FIGS. 11A and 11B are each a view showing one example of a display apparatus in accordance with one embodiment;
FIGS. 12A and 12B are each a view showing one example of a lighting apparatus and an automobile having a light fixture in accordance with one embodiment; and
FIGS. 13A and 13B are each a view showing one example of a wearable device in accordance with one embodiment.

## DESCRIPTION OF THE EMBODIMENTS

Below, embodiments of the present disclosure will be described by reference to the accompanying drawings. Incidentally, the present disclosure is not limited to the following embodiments, and can be appropriately changed within the scope not departing from the gist thereof. Further, in the drawings described below, those having the same function are given the same reference numeral and sign and may not be described or may be simplified.

First Embodiment

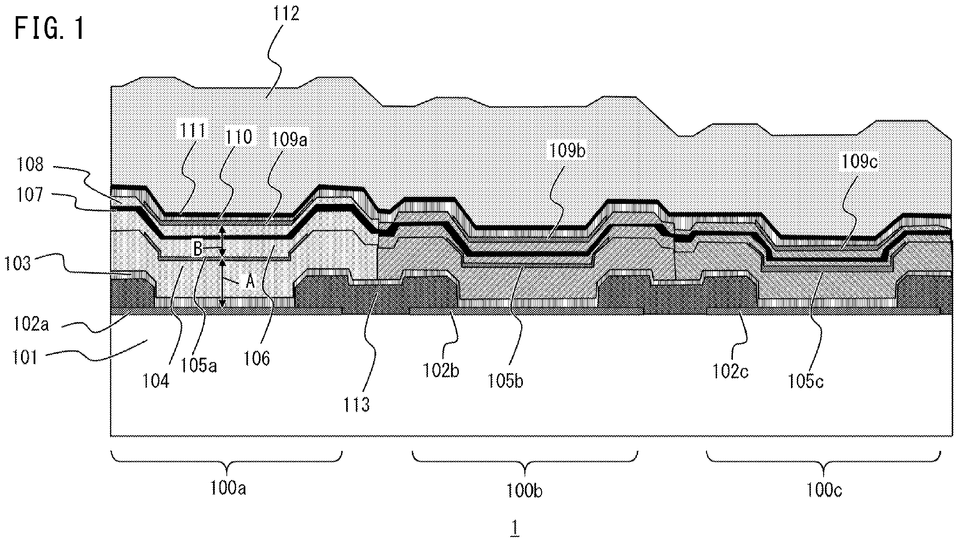

FIG. 1 is a cross sectional view showing one example of a first sub pixel 100a, a second sub pixel 100b, and a third sub pixel 100c of a light emitting element 1 in accordance with the present embodiment.
Herein, with the substrate 101 side assumed as the bottom, and the opposite side to the substrate 101 as the top, the light emitting element 1 of FIG. 1 is configured in the order of lower electrodes 102a to 102c, a first organic layer 103, a second organic layer 104, first light emitting layers 105a to 105c, and a third organic layer 106 on the substrate 101. Further, the light emitting element 1 is configured in the order of, on the third organic layer 106, a charge generation layer 107, a fourth organic layer 108, second light emitting layers 109a to 109c, a fifth organic layer 110, an upper electrode 111, and a protective layer 112. Furthermore, as shown, an insulation layer 113 covering both ends of the lower electrode 102a is provided. The insulation layer 113 is also referred to as a pixel separation film or a bank. Similarly, an insulation layer covering respective both ends of the lower electrodes 102b and 102c is provided.
Herein, the first sub pixel 100a is one example of the first element. The lower electrode 102a corresponds to a first lower electrode, the first light emitting layer 105a corresponds to a first light emitting layer for emitting light of a first color, and the second light emitting layer 109a corresponds to a second light emitting layer for emitting light of a first color. Further, the second sub pixel 100b is one example of a second element. The lower electrode 102b corresponds to a second lower electrode, the first light emitting layer 105b corresponds to a third light emitting layer for emitting light of a second color, and the second light emitting layer 109b corresponds to a fourth light emitting layer for emitting light of a second color.
For the light emitting element 1 of the present embodiment, the first light emitting layers 105a to 105c, and the second light emitting layer 109 are deposited by a so-called differently coating method. Namely, using, for example, a metal mask or photolithography, an organic layer is deposited for each color. As a result of this, the first light emitting layers 105a to 105c emit lights of different colors, respectively. Further, the second light emitting layers 109a to 109c also emit lights of different colors, respectively. Furthermore, in the present embodiment, at least one layer of the first organic layer 103, the second organic layer 104, the third organic layer 106, the fourth organic layer 108, and the fifth organic layer 110 is deposited by the differently coating method.
The light emitting element 1 of the present embodiment is a so-called tandem type light emitting element including a charge generation layer provided between a plurality of light emitting layers, and has a charge generation layer 107. The charge generation layer 107 is a layer for generating holes and electrons by being applied with a voltage between the lower electrode and the upper electrode. The charge generation layer 107 includes a compound which tends to receive electrons from other organic compounds. For example, the charge generation layer 107 is formed of a combination of an alkali metal and a compound with a lowest unoccupied molecular orbital level energy of -5.0 eV or less, and can function as a charge generation layer. The alkali metal configuring the charge generation layer 107 may be Li. Li may be used as a part of an organic metal complex even in the form of a metal simple substance or a part of a compound.

Further, the compound with a lowest unoccupied molecular orbital level energy of -5.0 eV or less for use in the charge generation layer 107 may be a hexaazatriphenylene compound, a radiallene compound, hexafluoroquinodimethane, or the like, but is not limited thereto. A lowest unoccupied molecular orbital level energy being low enough to extract electrons from the HOMO; Highest Occupied Molecular Orbital of the alkali metal enables electric charge generation to be performed.

As a result of this, positive and negative electric charges are generated at the charge generation layer 107. For this reason, the charge generation layer 107 can supply positive or negative electric charges to the overlying layer and the underlying layer of the charge generation layer 107. In other words, an electric field is applied between the lower electrode and the upper electrode, so that carriers are generated at the charge generation layer 107. Thus, the carriers are supplied to the first light emitting layers 105a to 105c and the second light emitting layers 109a to 109c. This can cause both the light emitting layers to emit light with efficiency.

The light emitting element 1 of the present embodiment adopts the differently coating method, and thereby is configured such that the groups of the first light emitting layers 105a to 105c and the second light emitting layers 109a to 109c may emit lights of the same color, respectively. For example, it may be configured such that the group of the first light emitting layer 105a and the second light emitting layer 109a may emit light of red color, such that the group of the first light emitting layer 105b and the second light emitting layer 109b may emit light of green color, and such that the group of the first light emitting layer 105c and the second light emitting layer 109c may emit light of blue color.

Further, the light emitting element 1 of the present embodiment is also of a so-called microcavity structure. Namely, Lr represents the optical path length from the upper surfaces of the lower electrodes 102a to 102c to the light emitting positions of the first light emitting layers 105a to 105c corresponding to the lower electrodes 102a to 102c, respectively. Further, Φr represents the phase shift when light with a wavelength of λ is reflected at the interface of the lower electrode 102. Then, the following equation (1) holds.

$$Lr = (2m - (\Phi r/\pi)) \times (\lambda/4) \cdots (1)$$

Herein, m is an integer of 0 or more. The optical distance of the first organic layer 103 and the second organic layer 104 can be optimized for each color so as to satisfy the equation (1). Herein, λ may be the main wavelength of the light emitting element 1. The main wavelength λ may be a wavelength to be emitted from the light emitting element, and to be extracted outside the light emitting element. Further, the main wavelength λ may be the maximum peak wavelength of the light emitting material possessed by the light emitting element.

A wavelength λ satisfying the equation (1) can intensify the light of each color emitted by the light emitting element 1. Even use of a wavelength λ within the range of the value shifted by $\pm\lambda/12$ can intensify the light emitted by the light emitting element 1. Namely, in the present embodiment, the wavelength λ satisfying the following equation (2) may be adopted.

$$Lr = (2m - (\Phi r/\pi)) \times (\lambda/4) \pm \lambda/12 \cdots (2)$$

Further, the following equation (3) holds where Ls represents the space or the optical distance between the light emitting positions of the first light emitting layers 105a to 105c and the reflection surface of the upper electrode 111, and Φs represents the phase shift when light with a wavelength of λ is reflected at the interface of the upper electrode 111. Incidentally, m' is an integer of 0 or more. In the present embodiment, m' = 0.

$$Ls = (2m'-(\Phi s/\pi)) \times (\lambda/4) = -(\Phi s/\pi) \times (\lambda/4) \cdots (3)$$

Further, as with the equation (1), a wavelength λ satisfying the equation (3) can intensify the light emitted by the light emitting element 1. Even use of the wavelength λ within the range of the value shifted by $\pm\lambda/12$ can intensify the light emitted by the light emitting element 1. Namely, in the present embodiment, the wavelength λ satisfying the following equation (4) may be adopted.

$$Ls = (2m' - (\Phi s/\pi)) \times (\lambda/4) \pm \lambda/12 = -(\Phi s/\pi) \times (\lambda/4) \pm \lambda/12 \cdots (4)$$

Therefore, for the optical path length L1 between the lower electrodes 202a to 202c and the first light emitting layers 105a to 105c, the conditions shown in the following equation (5) are satisfied from the equations (1) and (3).

$$L1 = Lr + Ls = (2m - \Phi/\pi) \times (\lambda/4) \cdots (5)$$

Herein, $\Phi$ represents the sum $\Phi r + \Phi s$ of respective phase shifts when light with a wavelength of $\lambda$ is reflected at the interface of the lower electrode 102 and the interface of the upper electrode 111.

Further, although a wavelength $\lambda$ satisfying the equation (5) can most intensify the light emitted by the light emitting element 1, even use of a wavelength $\lambda$ within the range of the value shifted by $\pm\lambda/12$ can intensify the light. Namely, in the present embodiment, the wavelength $\lambda$ satisfying the following equation (6) may be adopted.

$$L1 = Lr + Ls = (2m - \Phi/\pi) \times (\lambda/4) \pm \lambda/12 \cdots (6)$$

In the above description, the case of the first light emitting layers 105a to 105c was shown. The foregoing relationship also similarly holds for the second light emitting layers 109a to 109c. Therefore, the first light emitting layers 105a to 105c, and the second light emitting layers 109a to 109c are both configured as microcavity structures. As a result, the light emitting element 1 can implement light emission with higher efficiency than with the light emitting element by the related art technology.

Microcavity Effect By Light Emitting Element In Accordance With The Present Embodiment

Generally, for an AR panel, a panel with a strong directivity is preferable. For enhancing the directivity of the light emitted by the light emitting element 1, a larger order of interference of the microcavity structure is more preferable.

Herein, the order of interference corresponds to the value of m or m' of the equations (1) to (6), and the order of interference m or m' is 0 or a positive integer. When m = 0 or m' = 0, in each of the equations, the optical distance takes a positive minimum value satisfying the equation. In the present embodiment, the order of interference m between the upper surfaces of the lower electrodes 102a to 105c and the lower surfaces of the corresponding first light emitting layers 105a to 105c is 1. When the phase shift $\varphi$ is $-\pi$, the optical path length Lr becomes $3\lambda/4$. Further, the order of interference m between the upper surfaces of the lower electrodes 102a to 102c and the lower surfaces of the corresponding second light emitting layers 109a to 109c is 2. When the phase shift $\varphi$ is $-\pi$, the optical path length Lr becomes $5\lambda/4$.

For example, when the first sub pixel 100a is a pixel for emitting light of red color, the space between the upper surface of the lower electrode 102a and the lower surface of the first light emitting layer 105a is about 250 nm, and the space between the upper surface of the lower electrode 102a and the lower surface of the second light emitting layer 109a is about 410 nm. Then, the space between the upper surface of the first light emitting layer 105a and the second light emitting layer 109a is about 150 nm.

Further, as one example, when the second sub pixel 100b is a pixel for emitting light of green color, the space between the upper surface of the lower electrode 102b and the lower surface of the first light emitting layer 105b is about 200 nm, and the space between the upper surface of the lower electrode 102b and the lower surface of the second light emitting layer 109b is about 340 nm. Then, the space between the upper surface of the first light emitting layer 105b and the lower surface of the second light emitting layer 109b is about 120 nm.

Further, as one example, when the third sub pixel 100c is a pixel for emitting light of blue color, the space between the upper surface of the lower electrode 102c and the lower surface of the first light emitting layer 105c is about 170 nm, and the space between the upper surface of the lower electrode 102c and the lower surface of the second light emitting layer 109c is about 280 nm. Then, the space between the upper surface of the first light emitting layer 105c and the lower surface of the second light emitting layer 109c is about 100 nm.

Further, as shown, the thickness between the first light emitting layer 105a and the lower electrode 102a ("A" shown) is larger than the thickness between the first light emitting layer 105a and the second light emitting layer 109a ("B" shown). When the order of interference is large, by setting the thickness A between the first light emitting layer 105a and the lower electrode 102a of FIG. 1 larger than the thickness B between the first light emitting layer 105a and the second light emitting layer 109a, it becomes possible to enhance the efficiency of light emission due to the microcavity effect in the light emitting element 1. Incidentally, the same also applies to the relationship among the lower electrodes 102b and 102c, the first light emitting layers 105b and 105c, and the second light emitting layers 109b and 109c.

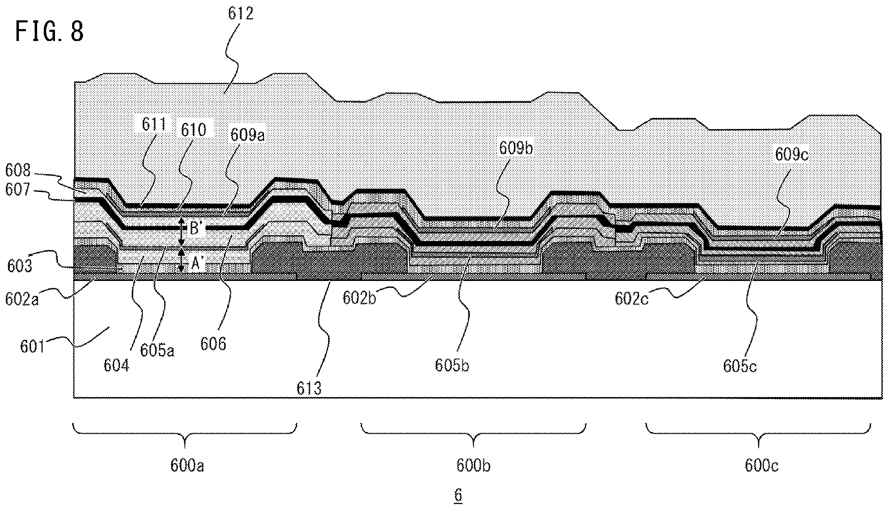

FIG. 8 shows a cross sectional view of a first sub pixel 600a, a second sub pixel 600b, and a third sub pixel 600c of a light emitting element 6 of the related art as a comparable example of the light emitting element 1 of the present embodiment. As shown in FIG. 8, for the light emitting element 6, on a substrate 601, lower electrodes 602a to 602c, a first organic layer 603, a second organic layer 604, a first light emitting layer 605a, a third organic layer 606, a charge generation layer 607, and a fourth organic layer 608 are formed in this order from the substrate 601 side. Further, for the light emitting element 6, a second light emitting layer 609a, a fifth organic layer 610, an upper electrode 611, and a protective layer 612 are formed in this order from the substrate 601 side on the fourth organic layer 608. Further, for the light emitting element 6, an insulation layer 613 covering the end of the lower electrode 602a is provided.

For the light emitting element 6, the thickness ("B'" shown) between the first light emitting layer 605a and the second light emitting layer 609a is larger than the thickness ("A'" shown) between the first light emitting layer 605a and the lower electrode 602a. Therefore, for the light emitting element 6, the order of interference m between the upper surface of the lower electrode 602a and the lower surface of the first light emitting layer 605a is 0, and the optical path length Lr when the phase shift $\varphi$ is $-\pi$ is $\lambda/4$. Further, the order of interference m between the upper surface of the lower electrode 602a and the lower surface of the second light emitting layer 609a is 0, and the optical path length Lr when the phase shift $\varphi$ is $-\pi$ is $3\lambda/4$.

For example, when the first sub pixel 600a is a pixel for emitting light of red color, the space between the upper surface of the lower electrode 602a and the lower surface of the first light emitting layer 605a is about 80 nm, and the space between the upper surface of the lower electrode 602a and the lower surface of the second light emitting layer 609a is about 250 nm. Then, the space between the upper surface of the first light emitting layer 605a and the lower surface of the second light emitting layer 609a is about 150 nm.

Further, as one example, when the second sub pixel 600b is a pixel for emitting light of green color, the space between the upper surface of the lower electrode 602b and the lower surface of the first light emitting layer 605b is about 60 nm, and the space between the upper surface of the lower electrode 602b and the lower surface of the second light emitting layer 609b is about 200 nm. Then, the space between the upper surface of the first light emitting layer 605b and the lower surface of the second light emitting layer 609b is about 120 nm.

Further, as one example, when the third sub pixel 600c is a pixel for emitting alight of blue color, the space between the upper surface of the lower electrode 602c and the lower surface of the first light emitting layer 605c is about 50 nm, and the space between the upper surface of the lower electrode 602c and the lower surface of the second light emitting layer 609c is about 170 nm. Then, the space between the upper surface of the first light emitting layer 605c and the lower surface of the second light emitting layer 609c is about 100 nm.

Therefore, when the order of interference becomes smaller, the relationship that the thickness B' between the first light emitting layer 605a and the second light emitting layer 609a is larger than the thickness A' between the first light emitting layer 605a and the lower electrode 602a does not hold.

As described up to this point, with the light emitting element 1 of the present embodiment, when the orders of interference between the first lower electrode and the first light emitting layer, and between the first lower electrode and the second light emitting layer are large, it is possible to enhance the luminous efficiency due to the microcavity effect.

Incidentally, with the light emitting element 1 in accordance with the present embodiment, the order of interference m between the upper surface of the lower electrode 102a and the lower surface of the first light emitting layer 105a was assumed to be 1. However, it is essential only that the order of interference m is 1 or more. Similarly, with the light emitting element 1, the order of interference m between the upper surface of the lower electrode 102a and the lower surface of the second light emitting layer 109a was assumed to be 2. However, it is essential only that the order of interference m is 2 or more.

Second Embodiment

Then, a description will be given to a light emitting element in accordance with a second embodiment. Incidentally, in the following description, the same configuration as that of the first embodiment is given the same reference numeral and sign, and will not be described in detail.

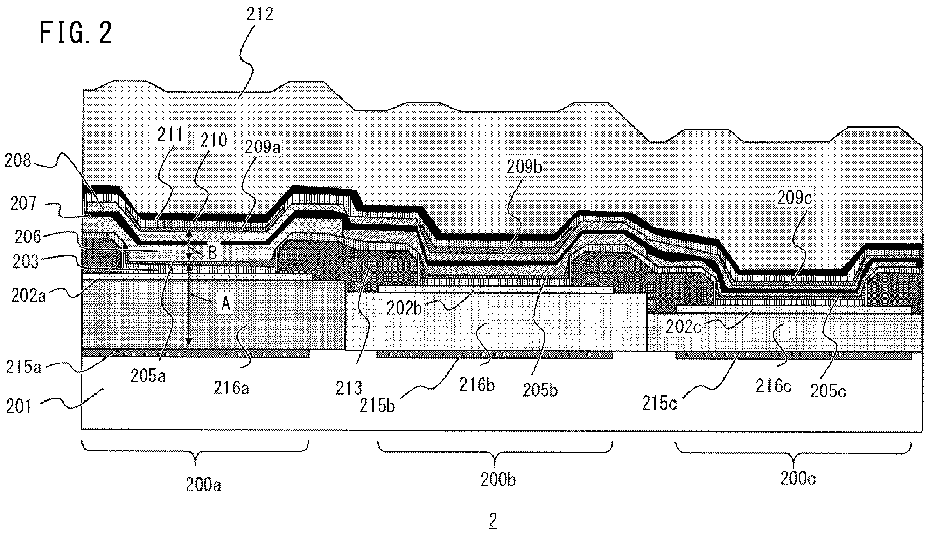

FIG. 2 shows a cross sectional view showing one example of a first sub pixel 200a, second sub pixel 200b, third sub pixel 200c of a light emitting element 2 in accordance with the present embodiment. As shown, the light emitting element 2 has a substrate 201, lower electrodes 202a to 202c, a first organic layer 203, and first light emitting layers 205a to 205c as with the light emitting element 1. Further, the light emitting element 2 has a third organic layer 206, a charge generation layer 207, a fourth organic layer 208, second light emitting layers 209a to 209c, a fifth organic layer 210, an upper electrode 211, a protective layer 212, and an insulation layer 213 as with the light emitting element 1.

For the light emitting element 2 of the present embodiment, further, reflection layers 215a to 215c and optical adjustment layers 216a to 216c are formed with respect to the light emitting element 1 of the first embodiment. The optical adjustment layers 216a to 216c each can include an insulation layer. Incidentally, the optical adjustment layer 216a is one example of the first optical adjustment layer, and the optical adjustment layer 216b is one example of the second optical adjustment layer.

For the light emitting element 2 of the present embodiment, a microcavity structure may be adopted, thereby making the thicknesses of the optical adjustment layers 216a to 216c vary among sub pixels. For example, the thickness of the optical adjustment layer 216a can be set so as to satisfy the interference conditions for red color, the thickness of the optical adjustment layer 216b can be set so as to satisfy the interference conditions for green color, and the thickness of the optical adjustment layer 216c can be set so as to satisfy the interference conditions for blue color.

Further, the optical path length between the upper surface of the reflection layer 215a and the light emitting position of the first light emitting layer 205a is assumed to be L1a. The optical path length L1a is the total sum of the optical distance between the upper surface of the lower electrode 202a and the first light emitting layer 205a, the optical distance of the thickness of the lower electrode 202a, and the optical distance of the thickness of the optical adjustment layer 216a. Further, the optical path length between the upper surface of the reflection layer 215b and the light emitting position of the first light emitting layer 205b is assumed to be L1b. The optical path length L1b is the total sum of the optical distance between the upper surface of the lower electrode 202b and the first light emitting layer 205b, the optical distance of the thickness of the lower electrode 202b, and the optical distance of the thickness of the optical adjustment layer 216b. Further, the optical path length between the upper surface of the reflection layer 215c and the light emitting position of the first light emitting layer 205c is assumed to be L1c. The optical path length L1c is the total sum of the optical distance between the upper surface of the lower electrode 202c and the first light emitting layer 205c, the optical distance of the thickness of the lower electrode 202c, and the optical distance of the thickness of the optical adjustment layer 216c.

Similarly, the optical path length between the upper surface of the reflection layer 215a and the light emitting position of the second light emitting layer 209a is assumed to be L2a. The optical path length L2a is the total sum of the optical distance between the upper surface of the lower electrode 202a and the second light emitting layer 209a, the optical distance of the thickness of the lower electrode 202a, and the thickness of the optical adjustment layer 216a. Further, the optical path length between the upper surface of the reflection layer 215b and the light emitting position of the second light emitting layer 209b is assumed to be L2b. The optical path length L2b is the total sum of the optical distance between the upper surface of the lower electrode 202b and the second light emitting layer 209b, the optical distance of the thickness of the lower electrode 202b, and the thickness of the optical adjustment layer 216b. Further, the optical path length between the upper surface of the reflection layer 215c and the light emitting position of the second light emitting layer 209c is assumed to be L2c. The optical path length L2c is the total sum of the optical distance between the upper surface of the lower electrode 202c and the second light emitting layer 209c, the optical distance of the thickness of the lower electrode 202c, and the thickness of the optical adjustment layer 216c.

Thus, the light emitting element 2 of the present embodiment is provided with an optical resonator structure for causing resonance by causing the reflection layer 215a to reflect the light emitted by the first light emitting layer 205a between the reflection layer 215a and the first light emitting layer 205a. Further, there is provided an optical resonator structure for causing resonance by causing the reflection layer 215b to reflect the light emitted by the first light emitting layer 205b between the reflection layer 215b and the first light emitting layer 205b. Still further, there is provided an optical resonator structure for resonating the light emitted by the first light emitting layer 205c between the reflection layer 215c and the first light emitting layer 205c. For the light emitting element 2 of the present embodiment, the total film thickness of the organic layers is reduced by the optical distance of respective thicknesses of the lower electrodes 202a to 202c and the optical adjustment layers 216a to 216c corresponding to the lower electrodes 202a to 202c, respectively. The smaller the total film thickness of the organic layers becomes, the smaller the voltage to be applied to the organic light emitting element becomes. Then, the total film thickness of the organic layers is reduced by the optical distance of respective thicknesses of the lower electrodes 202a to 202c and the optical adjustment layers 216a to 216c corresponding to the lower electrodes 202a to 202c, respectively, and the driving voltage is suppressed. As a result, the power consumption is reduced.

For example, in the first embodiment, for the first sub pixel 100a, the film thickness of the organic layers between the upper surface of the lower electrode 102a and the lower surface of the upper electrode 111 is about 470 nm. Further, for the second sub pixel 100b, the film thickness of the organic layers between the upper surface of the lower electrode 102b and the lower surface of the upper electrode 111 is about 390 nm. For the third sub pixel 100c, the film thickness of the organic layers between the upper surface of the lower electrode 102c and the lower surface of the upper electrode 111 is about 330 nm.

In the present embodiment, for the first sub pixel 200a, the film thickness of the organic layers between the upper surface of the lower electrode 202a and the lower surface of the upper electrode 211 is about 250 nm. Further, for the second sub pixel 100b, the film thickness of the organic layers between the upper surface of the lower electrode 202b and the lower surface of the upper electrode 211 is about 230 nm. For the third sub pixel 200c, the film thickness of the organic layers between the upper surface of the lower electrode 202c and the lower surface of the upper electrode 211 is about 210 nm.

Thus, with the light emitting element 2 of the present embodiment, each film thickness of the respective organic layers can be made smaller than that of the light emitting element 1 of the first embodiment. Then, the total film thickness of the organic layers is reduced by the optical distance between the lower electrodes 202a to 202c and the optical adjustment layers 216a to 216c, and the driving voltage is suppressed. As a result, the power consumption can be more reduced.

Further, in the present embodiment, when the order of interference m between the upper surfaces of the reflection layers 215a to 215c and the lower surfaces of the first light emitting layers 205a to 205c is 1, and the phase shift $\varphi$ is $-\pi$, the optical path length Lr becomes $3\lambda/4$. Further, when the order of interference m between the upper surfaces of the reflection layers 215a to 215c and the lower surfaces of the second light emitting layers 209a to 209c is 2, and the phase shift $\varphi$ is $-\pi$, the optical path length Lr becomes $5\lambda/4$.

For example, when the first sub pixel 200a is a pixel for emitting light of red color, the space between the upper surface of the reflection layer 215a and the lower surface of the first light emitting layer 205a is about 310 nm. The space between the upper surface of the reflection layer 215a and the lower surface of the second light emitting layer 209a is about 490 nm. Then, the space between the upper surface of the first light emitting layer 205a and the lower surface of the second light emitting layer 209a is about 160 nm.

Further, as one example, when the second sub pixel 200b is a pixel for emitting light of green color, the space between the upper surface of the reflection layer 215b and the lower surface of the first light emitting layer 205b is about 250 nm. The space between the upper surface of the reflection layer 215b and the lower surface of the second light emitting layer 209b is about 400 nm. Then, the space between the upper surface of the first light emitting layer 205c and the lower surface of the second light emitting layer 209c is about 140 nm.

Further, as one example, when the third sub pixel 200c is a pixel for emitting light of blue color, the space between the upper surface of the reflection layer 215c and the lower surface of the first light emitting layer 205c is about 210 nm. The space between the upper surface of the reflection layer 215c and the lower surface of the second light emitting layer 209c is about 360 nm. Then, the space between the upper surface of the first light emitting layer 205c and the lower surface of the second light emitting layer 209c is about 120 nm.

Therefore, it is understood that, for the light emitting element 2, as with the first embodiment, the thickness A between the first light emitting layer 205a and the reflection layer 215a is larger than the thickness B between the first light emitting layer 205a and the second light emitting layer 209a.

Generally, when the order of interference is increased in order to intensify the directivity of light emission of the light emitting element, the total film thickness of the organic layers increases, and driving of the light emitting element is increased in voltage. With the light emitting element 2 of the present embodiment, the total film thickness of the organic layers can be reduced by the optical distance between the lower electrodes 202a to 202c and the optical adjustment layers 216a to 216c. For this reason, it is possible to more reduce the driving voltage of the light emitting element.

Third Embodiment

Then, a description will be given to a light emitting element in accordance with a third embodiment. Incidentally, in the following description, the same configuration as that of the embodiment is given the same reference numeral and sign, and will not be described in detail.

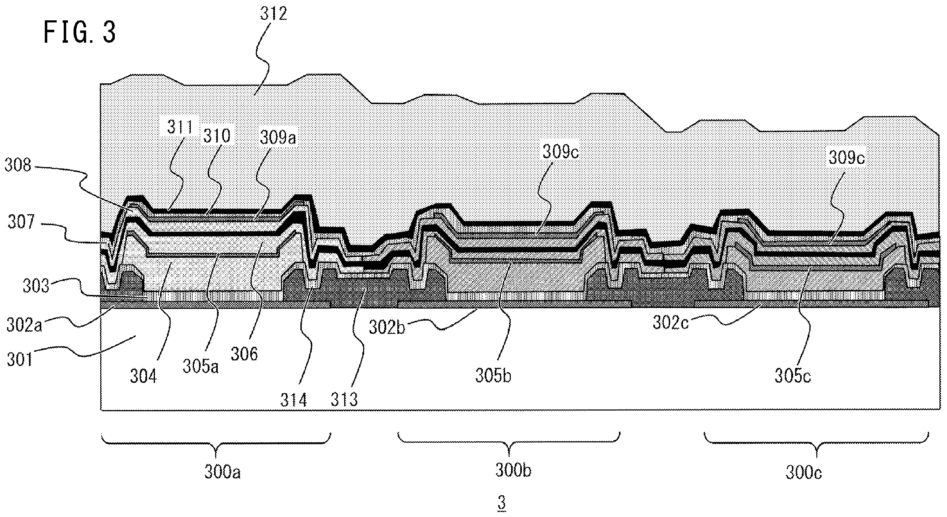

FIG. 3 is a cross sectional view showing one example of a first sub pixel 300a, second sub pixel 300b, and a third sub pixel 300c of a light emitting element 3 in accordance with the present embodiment. As shown, the light emitting element 3 has a substrate 301, lower electrodes 302a to 302c, a first organic layer 303, and first light emitting layers 305a to 305c as with the light emitting element 1. Further, the light emitting element 3 has a third organic layer 306, a charge generation layer 307, a fourth organic layer 308, second light emitting layers 309a to 309c, a fifth organic layer 310, an upper electrode 311, a protective layer 312, and an insulation layer 313 as with the light emitting element 1. With the light emitting element 3 of the present embodiment, with respect to the light emitting element 1 of the first embodiment, a groove 314 is further formed as a separation structure on the surface on the organic layer side at the insulation layer 313.

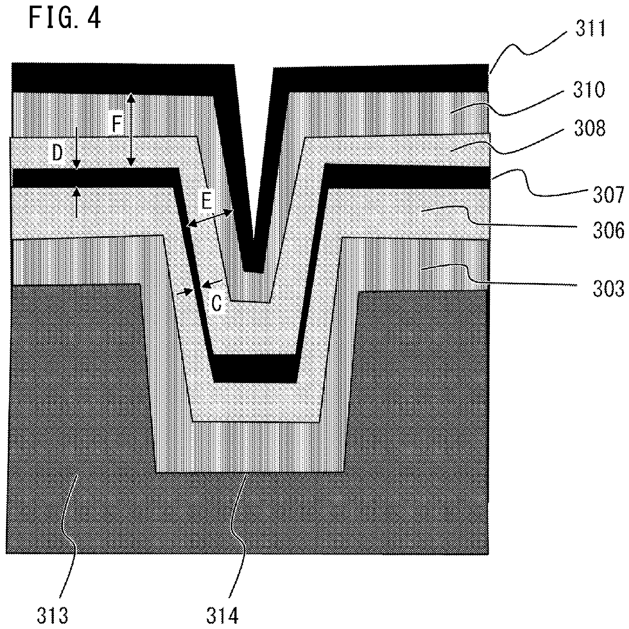

FIG. 4 is a cross sectional view of the vicinity of the groove 314 of FIG. 3 on an enlarged scale. For the light emitting element 3 of the present embodiment, in the inside of the groove 314, a first organic layer 303, a third organic layer 306, a charge generation layer 307, a fourth organic layer 308, a fifth organic layer 310, and an upper electrode 311 are formed from the insulation layer 313 side (the substrate 301 side).

The charge generation layer 307 may be configured so as to be shared among a plurality of sub pixels. In that case, the electric charges supplied from the charge generation layer 307 may be supplied to the adjacent sub pixel. In order to reduce the leakage current between such sub pixels, the groove 314 is formed in the light emitting element 3. The thickness ("E" shown) of the organic compound layer in the inside of the groove 314 is smaller than the thickness ("F" shown) of the organic compound layer in the outside of the groove 314, so that the resistance of the inside of the groove 314 becomes higher. As a result of this, the leakage current between the adjacent sub pixels is suppressed, which can suppress the color mixture between sub pixels having mutually different luminescent colors.

For the light emitting element 3, when the order of interference is increased in order to intensify the directivity of the emitted light, the film thickness of the organic layer between the lower electrodes 302a to 302c and the charge generation layer 307 increases. Accordingly, the groove 314 becomes more likely to be filled with the organic layer.

For the light emitting element 3, the second organic layer 304, the first light emitting layers 305a to 305c are not deposited in the inside of the groove 314 by the differently coating method. As a result of this, the groove 314 is not filled with the organic layer at the time of deposition of the charge generation layer 307, so that at the groove 314, the charge generation layer 307 is formed in the groove 314. The thickness ("C" shown) of the charge generation layer 307 in the inside of the groove 314 is smaller than the thickness ("D" shown) of the charge generation layer 207 at the flat part in the outside of the groove 314. As a result of this, the resistance of the inside of the groove 314 increases, which suppresses the leakage current between the adjacent sub pixels.

Further, at the groove 314, the formation of the fourth organic layer 308 and the fifth organic layer 310 in the groove suppresses the reduction of the thickness of the organic layers between the charge generation layer 307 and the upper electrode 311 in the inside of the groove 314. As a result of this, it is possible to suppress the leakage current generated between the charge generation layer 307 and the upper electrode 311.

Therefore, with the light emitting element 3 in accordance with the present embodiment, while intensifying the directivity of the emitted light, the leakage current between the sub pixels can be suppressed, and further the leakage current between the charge generation layer and the upper electrode can also be suppressed.

Fourth Embodiment

Then, a description will be given to a light emitting element in accordance with a fourth embodiment. Incidentally, in the following description, the same configuration as that of the embodiment will be given the same reference numeral and sign, and will not be described in detail.

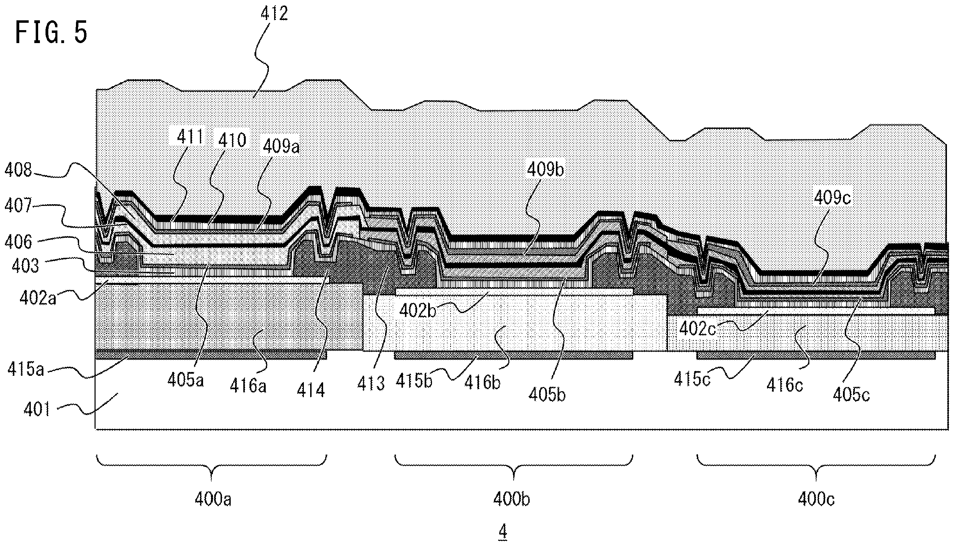

FIG. 5 is a cross sectional view showing one example of a first sub pixel 400a, a second sub pixel 400b, and a third sub pixel 400c of a light emitting element 4 in accordance with the present embodiment. As shown, the light emitting element 4 has a substrate 401, lower electrodes 402a to 402c, a first organic layer 403, and first light emitting layers 405a to 405c as with the light emitting element 2. Further, the light emitting element 4 has a third organic layer 406, a charge generation layer 407, a fourth organic layer 408, second light emitting layers 409a to 409c, a fifth organic layer 410, an upper electrode 411, a protective layer 412, and an insulation layer 413 as with the light emitting element 2. Further, the light emitting element 4 has reflection layers 415a to 415c, and optical adjustment layers 416a to 416c as with the light emitting element 2. For the light emitting element 4 of the present embodiment, a groove 414 is further formed on the surface on the organic layer side as a separation structure at the insulation layer 413 with respect to the light emitting element 2.

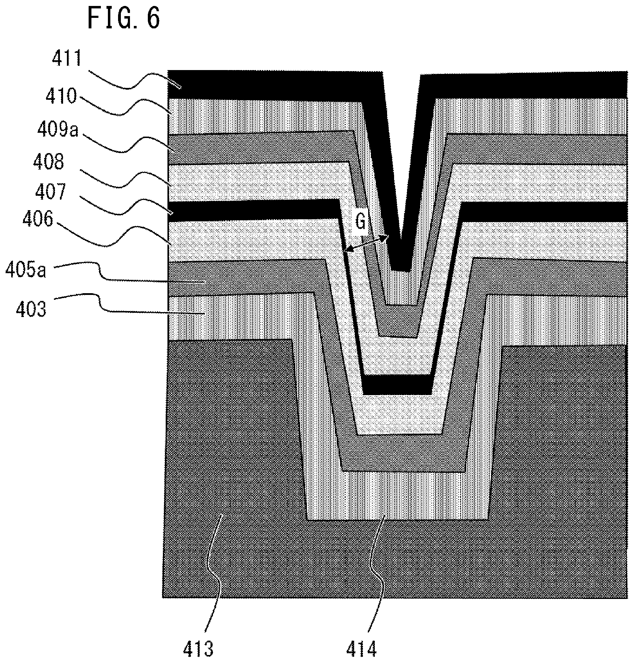

FIG. 6 is a cross sectional view showing the vicinity of the groove 414 of FIG. 5 on an enlarged scale. For the light emitting element 4, in the inside of the groove 414, from the insulation layer 413 side (the substrate 401 side), the first organic layer 403, the first light emitting layer 405a, the third organic layer 406, the charge generation layer 407, the fourth organic layer 408, the second light emitting layer 409a, the fifth organic layer 410, and the upper electrode 411 are formed.

For the light emitting element 4 of the present embodiment, the film thickness of the organic layers between the lower electrodes 402a to 402c and the corresponding first light emitting layers 405a to 405c can be reduced by the optical distance between the lower electrodes 402a to 402c and the corresponding optical adjustment layers 416a to 416c. As a result of this, at the time of deposition of the charge generation layer 407, the groove 414 is not filled with the organic layer, and the charge generation layer 407 is formed in the inside of the groove 414. Further, between the charge generation layer 407 and the upper electrode 411, a fourth organic layer 408, a second light emitting layer 409, and a fifth organic layer 410 are formed in the inside of the groove 414.

Thus, the fourth organic layer 408, the second light emitting layer 409, and the fifth organic layer 410 are formed in the inside of the groove 414. This suppresses the reduction of the thickness ("G" shown) between the charge generation layer 407 and the upper electrode 411 in the inside of the groove 414.

Therefore, with the light emitting element 4 of the present embodiment, the reduction of the thickness of the organic layer between the charge generation layer 407 and the upper electrode 411 in the inside of the groove 414 can be suppressed, and the leakage current between the charge generation layer 407 and the upper electrode 411 can be suppressed. Then, for the light emitting element 4, while intensifying the directivity of the light emitted by the light emitting element 4, the total film thickness of the organic layers can be reduced. For this reason, the driving voltage of the light emitting element can be reduced. Further, with the light emitting element 4, while suppressing the leakage current between the sub pixels, the leakage current between the charge generation layer and the upper electrode can also be suppressed.

Fifth Embodiment

Then, a description will be given to a light emitting element in accordance with a fifth embodiment. Incidentally, in the following description, the same configuration as that of the embodiment is given the same reference numeral and sign, and will not be described in detail.

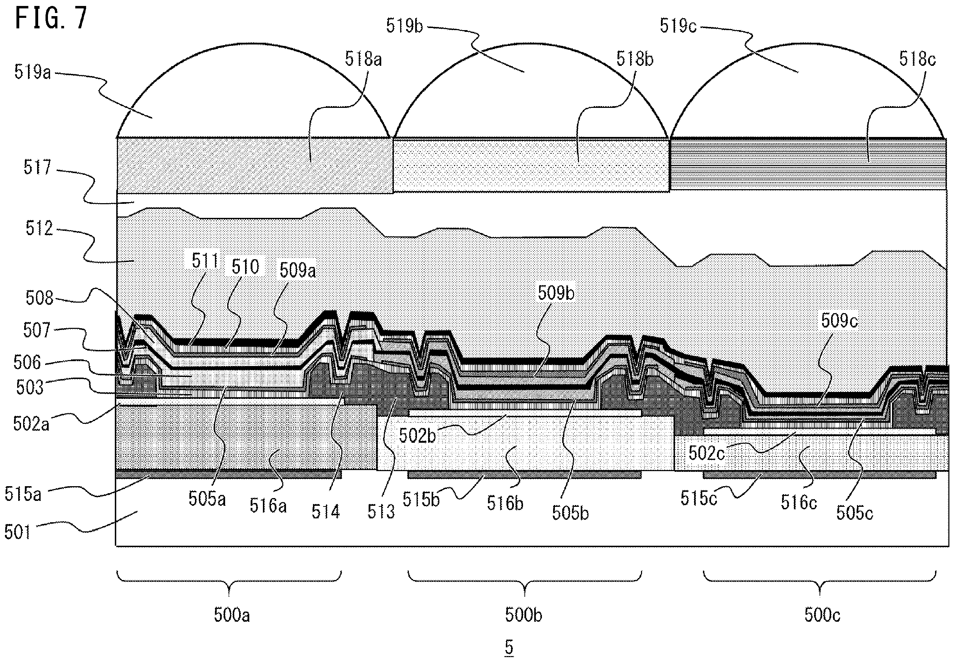

FIG. 7 is a cross sectional view showing one example of a first sub pixel 500a, a second sub pixel 500b, and a fifth sub pixel 500c of a light emitting element 5 in accordance with the present embodiment. As shown, the light emitting element 5 has a substrate 501, lower electrodes 502a to 502c, a first organic layer 503, and first light emitting layers 505a to 505c as with the light emitting element 4. Further, the light emitting element 5 has a third organic layer 506, a charge generation layer 507, a fourth organic layer 508, second light emitting layers 509a to 509c, a fifth organic layer 510, an upper electrode 511, a protective layer 512, and an insulation layer 513 as with the light emitting element 4. Further, the light emitting element 5 has reflection layers 515a to 515c, and optical adjustment layers 516a to 516c as with the light emitting element 4. Still further, for the light emitting element 5, a groove 514 is formed on the surface on the organic layer side as a separation structure at the insulation layer 513.

For the light emitting element 5 of the present embodiment, a flatten layer 517 is formed with respect to the light emitting element 4 of the fourth embodiment. On the flatten layer 517, color filters 518a to 518c corresponding to the sub pixels 500a to 500c, respectively, are arranged. The color filters 518a, 518b, and 518c are respectively color filters for transmitting lights of mutually different colors therethrough. Incidentally, for the light emitting element 5, the color filters 518a, 518b, and 518c are not required to be provided.

Further, on the color filters 518a, 518b, and 518c, microlenses 519a to 519c corresponding to the sub pixels 500a to 500c, respectively, are formed. Therefore, with the light emitting element 5 of the present embodiment, while suppressing the leakage current between the charge generation layer 507 and the upper electrode 511, the lights of respective colors emitted from the sub pixels 500a to 500c can be extracted with efficiency by the microlenses 519a to 519c.

(Configuration of an Organic Light-Emitting Element) In the present embodiment the organic light-emitting element is provided through formation of an insulating layer, a first electrode, an organic compound layer and a second electrode, on a substrate. A protective layer, a color filter, a microlens and so forth may be provided on a cathode. In a case where a color filter is provided, a planarization layer may be provided between the color filter and the protective layer. The planarization layer can be for instance made up of an acrylic resin. The same is true in a case where the planarization layer is provided between the color filter and the microlens.

(Substrate) At least one material selected from quartz, glass, silicon, resins and metals can be used as the material for the substrate that makes up the organic light-emitting element. Switching elements such as transistors, and wiring, may be provided on the substrate, and an insulating layer may be provided on the foregoing. Any material can be used as the insulating layer, so long as a contact hole can be formed between the insulating layer and the first electrode, and insulation from unconnected wiring can be ensured, so that wiring can be formed between the first electrode and the insulating layer. For instance a resin such as a polyimide, or silicon oxide or silicon nitride, can be used herein.

(Electrodes) A pair of electrodes can be used as the electrodes of the organic light-emitting element. The pair of electrodes may be an anode and a cathode. In a case where an electric field is applied in the direction in which the organic light-emitting element emits light, the electrode of higher potential is the anode, and the other electrode is the cathode. Stated otherwise, the electrode that supplies holes to the light-emitting layer is the anode, and the electrode that supplies electrons is the cathode.

A material having a work function as large as possible is preferable herein as a constituent material of the anode. For instance single metals such as gold, platinum, silver, copper, nickel, palladium, cobalt, selenium, vanadium or tungsten, and mixtures containing the foregoing metals, can be used in the anode. Alternatively, alloys obtained by combining these single metals, or metal oxides such as tin oxide, zinc oxide, indium oxide, indium tin oxide (ITO) or indium zinc oxide, may be used in the anode. Conductive polymers such as polyaniline, polypyrrole and polythiophene can also be used in the anode.

Any of the foregoing electrode materials may be used singly; alternatively, two or more materials may be used concomitantly. The anode may be made up of a single layer, or may be made up of a plurality of layers.

In a case where an electrode of the organic light-emitting element is configured in the form of a reflective electrode, the electrode material can be for instance chromium, aluminum, silver, titanium, tungsten, molybdenum, or alloys or layered bodies of the foregoing. The above materials can also function as a reflective film not having a role as an electrode. In a case where an electrode of the organic light-emitting element is configured in the form of a transparent electrode, for instance an oxide transparent conductive layer of indium tin oxide (ITO), indium zinc oxide or the like can be used, but the material is not limited to the foregoing. The electrodes may be formed by photolithography.

A material having a small work function may be a constituent material of the cathode. Examples include alkali metals such as lithium, alkaline earth metals such as calcium, single metals such as aluminum, titanium, manganese, silver, lead or chromium, and mixtures of the foregoing. Alternatively, alloys obtained by combining these single metals can also be used. For instance magnesium-silver, aluminum-lithium, aluminum-magnesium, silver-copper or zinc-silver can be used. Metal oxides such as indium tin oxide (ITO) can also be used. These electrode materials may be used singly as one type, or two or more types can be used concomitantly. The cathode may have a single-layer structure or a multilayer structure. Silver is preferably used among the foregoing, and more preferably a silver alloy, in order to reduce silver aggregation. Any alloy ratio can be adopted, so long as silver aggregation can be reduced. A ratio silver : other metal may be for instance 1:1, or 3:1.

Although not particularly limited thereto, the cathode may be a top emission element that utilizes an oxide conductive layer of ITO or the like, or may be a bottom emission element that utilizes a reflective electrode of aluminum (Al) or the like. The method for forming the cathode is not particularly limited, but more preferably for instance DC or AC sputtering is resorted to, since in that case film coverage is good and resistance can be readily lowered.

(Pixel Separation Layer) The pixel separation layer is formed out of a silicon nitride (SiN) film, a silicon oxynitride (SiON) film, or a silicon oxide (SiO) film, in turn having been formed by chemical vapor deposition (CVD). In order to increase the in-plane resistance of the organic compound layer, preferably the thickness of the organic compound layer that is formed, particularly a hole transport layer, is set to be small at the side walls of the pixel separation layer. Specifically, the side walls can be formed to be thin by increasing vignetting at the time of deposition, through an increase of the taper angle of the side walls of the pixel separation layer and/or an increase of the thickness of the pixel separation layer.

On the other hand, it is preferable to adjust the side wall taper angle of the pixel separation layer and/or the thickness of the pixel separation layer so that no voids are formed in the protective layer that is formed on the pixel separation layer. The occurrence of defects in the protective layer can be reduced by virtue of the fact that no voids are formed therein. Since the occurrence of defects in the protective layer is thus reduced, it becomes possible to reduce loss of reliability for instance in terms of the occurrence of dark spots, or defective conduction in the second electrode.

The present embodiment allows effectively suppressing leakage of charge to adjacent pixels even when the taper angle of the side walls of the pixel separation layer is not sharp. Studies by the inventors of the present application have revealed that leakage of charge to adjacent pixels can be sufficiently reduced if the taper angle lies in the range from 60 degrees to 90 degrees. The thickness of the pixel separation layer is preferably at least 10 nm and not more than 150 nm. A similar effect can be achieved also in a configuration having only a pixel electrode lacking a pixel separation layer. In this case, however, it is preferable to set the film thickness of the pixel electrode to be half or less the thickness the organic layer, or to impart forward taper at the ends of the pixel electrode, at a taper angle smaller than 60 degrees, since short circuits of the organic light-emitting element can be reduced thereby.

(Organic Compound Layer) The organic compound layer of the organic light-emitting element may be formed out of a single layer or multiple layers. In a case where the organic compound layer has multiple layers, these may be referred to as a hole injection layer, a hole transport layer, an electron blocking layer, a light-emitting layer, a hole blocking layer, an electron transport layer or an electron injection layer, depending on the function of the layer. The organic compound layer is mainly made up of organic compounds, but may contain inorganic atoms and inorganic compounds. For instance the organic compound layer may have copper, lithium, magnesium, aluminum, iridium, platinum, molybdenum or zinc. The organic compound layer may be disposed between the first electrode and the second electrode, and may be disposed in contact with the first electrode and the second electrode.

(Protective Layer) In the organic light-emitting element of the present embodiment a protective layer may be provided on the second electrode. For instance, intrusion of water or the like into the organic compound layer can be reduced, and the occurrence of display defects also reduced, by bonding glass having a moisture absorbent onto the second electrode. In another embodiment, a passivation film made up of silicon nitride or the like may be provided on the cathode, to reduce intrusion of water or the like into the organic compound layer. For instance, formation of the cathode may be followed by conveyance to another chamber, without breaking vacuum, whereupon a protective layer may be formed through formation of a silicon nitride film having a thickness of 2 $\mu$m, by CVD. The protective layer may be provided by atomic deposition (ALD), after film formation by CVD. The material of the film formed by ALD is not limited, but may be for instance silicon nitride, silicon oxide or aluminum oxide. Silicon nitride may be further formed, by CVD, on the film having been formed by ALD. The film formed by ALD may be thinner than the film formed by CVD. Specifically, the thickness of the film formed by ALD may be 50% or less, or 10% or less.

(Color Filter) A color filter may be provided on the protective layer of the organic light-emitting element of the present embodiment. For instance a color filter having factored therein the size of the organic light-emitting element may be provided on another substrate, followed by affixing to a substrate having the organic light-emitting element provided thereon; alternatively, a color filter may be patterned by photolithography onto the protective layer illustrated above. The color filter may be made up of a polymer.

(Planarization Layer) The organic light-emitting element of the present embodiment may have a planarization layer between the color filter and the protective layer. The planarization layer is provided for the purpose of reducing underlying layer unevenness. The planarization layer may be referred to as a resin layer in a case where the purpose of the planarization layer is not limited. The planarization layer may be made up of an organic compound, which may be a low-molecular or high-molecular compound, but is preferably a high-molecular compound.

The planarization layer may be provided above and below the color filter, and the constituent materials of the respective planarization layers may be identical or dissimilar. Concrete examples include polyvinylcarbazole resins, polycarbonate resins, polyester resins, ABS resins, acrylic resins, polyimide resins, phenolic resins, epoxy resins, silicone resins and urea resins.

(Microlens) The organic light-emitting element may have an optical member such as a microlens, on the light exit side. The microlens may be made up of for instance an acrylic resin or an epoxy resin. The purpose of the microlens may be to increase the amount of light extracted from the organic light-emitting element, and to control the direction of the extracted light. The microlens may have a hemispherical shape. In a case where the microlens has a hemispherical shape, then from among tangent lines that are in contact with the hemisphere there is a tangent line that is parallel to the insulating layer, such that the point of contact between that tangent line and the hemisphere is the apex of the microlens. The apex of the microlens can be established similarly in any cross section. That is, among tangent lines that are in contact with a semicircle of the microlens in a sectional view, there is a tangent line that is parallel to the insulating layer, such that the point of contact between that tangent line and the semicircle is the apex of the microlens.

A midpoint of the microlens can also be defined. Given a hypothetical line segment from the end point of an arc shape to the end point of another arc shape, in a cross section of the microlens, the midpoint of that line segment can be referred to as the midpoint of the microlens. The cross section for discriminating the apex and the midpoint may be a cross section that is perpendicular to the insulating layer.

The microlens has a first surface with a protruded portion and a second surface on the reverse side from that of the first surface. Preferably, the second surface is disposed closer to a functional layer than the first surface. In adopting such a configuration, the microlens must be formed on the organic light-emitting element. In a case where the functional layer is an organic layer, it is preferable to avoid high-temperature processes in the production process. If a configuration is adopted in which the second surface is disposed closer to the functional layer than the first surface, the glass transition temperatures of all the organic compounds that make up the organic layer are preferably 100°C or higher, and more preferably 130°C or higher.

(Counter Substrate) The organic light-emitting element of the present embodiment may have a counter substrate on the planarization layer. The counter substrate is thus called because it is provided at a position corresponding to the above-described substrate. Constituent materials of the counter substrate may be identical to those of the substrate described above. The counter substrate can be used as the second substrate in a case where the substrate described above is used as the first substrate.

(Organic Layer) Each organic compound layer (hole injection layer, hole transport layer, electron blocking layer, light-emitting layer, hole blocking layer, electron transport layer, electron injection layer and so forth) that makes up the organic light-emitting element of the present embodiment is formed in accordance with one of the methods illustrated below.

A dry process such as vacuum deposition, ionization deposition, sputtering, plasma or the like can be used for the organic compound layers that make up the organic light-emitting element of the present embodiment. A wet process in which a layer is formed through dissolution in an appropriate solvent, relying on a known coating method (for instance spin coating, dipping, casting, LB film deposition or inkjet) can resorted to instead of a dry process.

When a layer is formed for instance by vacuum deposition or by solution coating, crystallization or the like is unlikelier occur; this translates into superior stability over time. In a case where a film is formed in accordance with a coating method, the film can be formed by being combined with an appropriate binder resin.

Examples of binder resins include, although not limited to, polyvinylcarbazole resins, polycarbonate resins, polyester resins, ABS resins, acrylic resins, polyimide resins, phenolic resins, epoxy resins, silicone resins and urea resins. These binder resins may be used singly as one type, in the form of homopolymers or copolymers; alternatively, two or more types of binder resin may be used in the form of mixtures. Additives such as known plasticizers, antioxidants and ultraviolet absorbers may be further used concomitantly, as needed.

(Pixel Circuit) A light-emitting device having the organic light-emitting element of the present embodiment may have pixel circuits connected to respective organic light-emitting elements. The pixel circuits may be of active matrix type, and may control independently emission of light by a first organic light-emitting element and a second organic light-emitting element. Active matrix circuits may be voltage-programmed or current-programmed. A drive circuit has a pixel circuit for each pixel. Each pixel circuit may have an organic light-emitting element, a transistor that controls the emission luminance of the organic light-emitting element, a transistor that controls emission timing, a capacitor which holds the gate voltage of the transistor that controls emission luminance, and a transistor for connection to GND bypassing the light-emitting element.

The light-emitting device has a display area and a peripheral area disposed around the display area. The display area has pixel circuits, and the peripheral area has a display control circuit. The mobility of the transistors that make up the pixel circuits may be lower than the mobility of the transistors that make up the display control circuit. The slope of the current-voltage characteristic of the transistors that make up the pixel circuits may be gentler than the slope of the current-voltage characteristic of the transistors that make up the display control circuit. The slope of the current-voltage characteristics can be measured on the basis of a so-called Vg-Ig characteristic. The transistors that make up the pixel circuits are connected to light-emitting elements such as the first organic light-emitting element.

(Pixels) The organic light-emitting element of the present embodiment has a plurality of pixels. The pixels have sub-pixels that emit mutually different colors. The sub-pixels may have for instance respective RGB emission colors. The pixels emit light in a region referred to as pixel opening. This region is the same as the first region. The pixel openings may be 15 μm or smaller, and may be 5 μm or larger. More specifically, the pixel openings may be 11 μm, 9.5 μm, 7.4 μm or 6.4 μm. The spacing between sub-pixels may be 10 μm or less, and specifically, may be 8 μm, or 7.4 μm, or 6.4 μm.

The pixels can have any known arrangement in a plan view. For instance, the pixel layout may be a stripe arrangement, a delta arrangement, a pentile arrangement or a Bayer arrangement. The shape of the sub-pixels in a plan view may be any known shape. For instance, the sub-pixel shape may be for example quadrangular, such as rectangular or rhomboidal, or may be hexagonal. If the shape of the sub-pixels is close to that of a rectangle, the shape is deemed to fall under a rectangular shape. Therefore, the shape of the sub-pixels may be any shape that approximates any of the above-mentioned known shapes. Sub-pixel shapes and pixel arrays can be combined with each other.

(Use of the Organic Light-Emitting Element) The organic light-emitting element according to the present embodiment can be used as a constituent member of a display device or of a lighting device. Other uses of the organic light-emitting element include exposure light sources for electrophotographic image forming apparatuses, backlights for liquid crystal display devices, and light-emitting devices having color filters, in white light sources.

The display device may be an image information processing device having an image input unit for input of image information, for instance from an area CCD, a linear CCD or a memory card, and an information processing unit for processing inputted information, such that an inputted image is displayed on a display unit.

A display unit of an imaging device or of an inkj et printer may have a touch panel function. The driving scheme of this touch panel function may be an infrared scheme, a capacitive scheme, a resistive film scheme or an electromagnetic induction scheme, and is not particularly limited. The display device may also be used in a display unit of a multi-function printer.

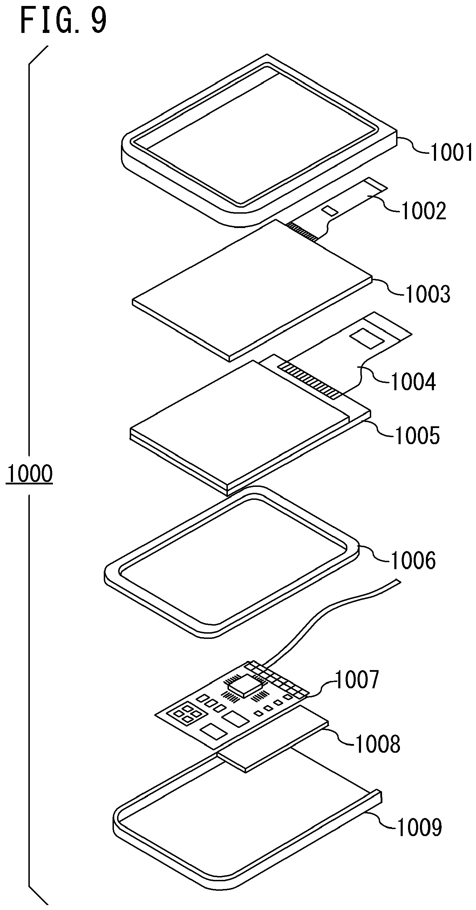

Next, FIG. 9 illustrates a schematic diagram depicting an example of a display device as a display apparatus having an organic light-emitting element according to the present embodiment. A display device 1000 may have a touch panel 1003, a display panel 1005, a frame 1006, a circuit board 1007 and a battery 1008, between an upper cover 1001 and a lower cover 1009. The touch panel 1003 and the display panel 1005 are connected to flexible printed circuits FPCs 1002, 1004. Transistors are printed on the circuit board 1007. The battery 1008 may be omitted if the display device is not a portable device; even if the display device is a portable device, the battery 1008 may be provided at a different position.

The display device 1000 may have red, green and blue color filters. The color filters may be disposed in a delta arrangement of the above red, green and blue. The display device 1000 may be used as a display unit of a mobile terminal. In that case the display device 1000 may have both a display function and an operation function. Mobile terminals include mobile phones such as smartphones, tablets and head-mounted displays.

The display device 1000 may be used in a display unit of an imaging device that has an optical unit having a plurality of lenses, and that has an imaging element which receives light having passed through the optical unit. The imaging device may have a display unit that displays information acquired by the imaging element. The display unit may be a display unit exposed outside the imaging device, or may be a display unit disposed within a viewfinder. The imaging device may be a digital camera or a digital video camera.

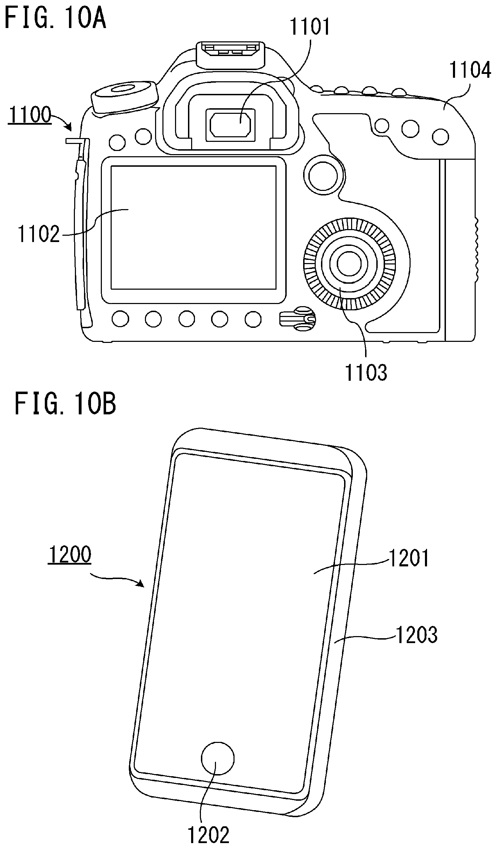

Next, FIG. 10A illustrates a schematic diagram depicting an example of an imaging device having the organic light-emitting element according to the present embodiment. An imaging device 1100 may have a viewfinder 1101, a rear display 1102, an operation unit 1103 and a housing 1104. The viewfinder 1101 may have the display device according to the present embodiment. In that case the display device may display not only an image to be captured, but also for instance environment information and imaging instructions. The environment information may include for instance external light intensity, external light orientation, the moving speed of a subject, and the chance of the subject being blocked by an obstacle.

The timing suitable for imaging is short, and hence information should be displayed as soon as possible. It is therefore preferable to configure the display device so as to have high response speed, using the organic light-emitting element of the present embodiment. A display device that utilizes the organic light-emitting element can be utilized more suitably than these devices or liquid crystal display devices, where high display speed is required.

The imaging device 1100 has an optical unit, not shown. The optical unit has a plurality of lenses, and forms an image on an imaging element accommodated in the housing 1104. The lenses can be focused through adjustment of the relative positions thereof. This operation can also be performed automatically. The imaging device may be referred to as a photoelectric conversion device. The photoelectric conversion device can encompass, as an imaging method other than sequential imaging, a method that involves detecting a difference relative to a previous image, and a method that involves cutting out part of a recorded image.

FIG. 10B is a schematic diagram illustrating an example of electronic equipment having the organic light-emitting element according to the present embodiment. Electronic equipment 1200 includes a display unit 1201, an operation unit 1202, and a housing 1203. The housing 1203 may have a circuit, a printed board having the circuit, a battery, and a communication unit. The operation unit 1202 may be a button, or a touch panel-type reaction unit. The operation unit may be a biometric recognition unit which for instance performs unlocking upon recognition of a fingerprint. The electronic equipment having a communication unit can also be referred to as a communication device. The electronic equipment 1200 may further have a camera function, by being provided with a lens and an imaging element. Images captured by way of the camera function are displayed on the display unit. Examples of the electronic equipment include smartphones and notebook computers.

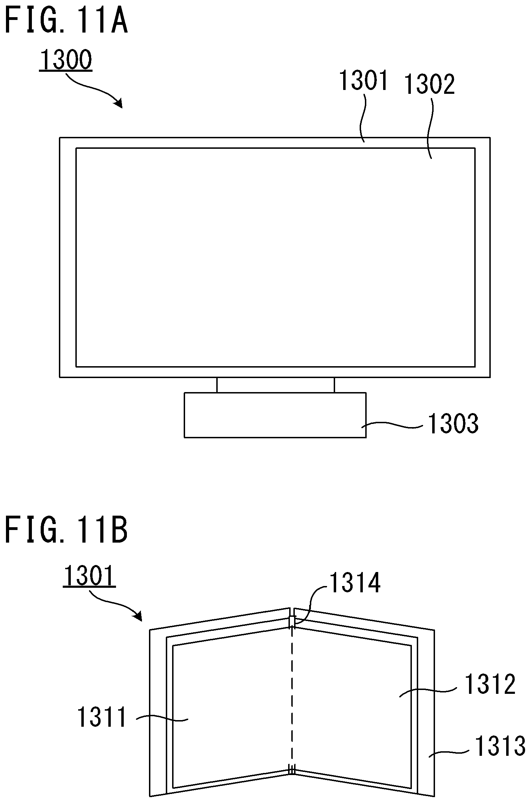

Next, FIG. 11A illustrates a schematic diagram depicting an example of a display device having the organic light-emitting element according to the present embodiment. FIG. 11A illustrates a display device 1300 such as a television monitor or PC monitor. The display device 1300 has a frame 1301 and a display unit 1302. The display unit 1302 may use the organic light-emitting element according to the present embodiment. The display device 1300 also has the frame 1301 and a base 1303 that supports the display unit 1302. The form of the base 1303 is not limited to the form in FIG. 11A. The lower side of the frame 1301 may also double as the base. The frame 1301 and the display unit 1302 may be curved. The radius of curvature of the foregoing may be at least 5000 mm and not more than 6000 mm.

FIG. 11B is a schematic diagram illustrating another example of a display device having the organic light-emitting element according to the present embodiment. A display device 1310 in FIG. 11B is a so-called foldable display device, configured to be foldable. The display device 1310 has a first display unit 1311, a second display unit 1312, a housing 1313 and a folding point 1314. The first display unit 1311 and the second display unit 1312 may have the organic light-emitting element according to the present embodiment. The first display unit 1311 and the second display unit 1312 may be one seamless display device. The first display unit 1311 and the second display unit 1312 can be separated at the folding point. The first display unit 1311 and the second display unit 1312 may display different images; alternatively, the first display unit and the second display unit may display one image.

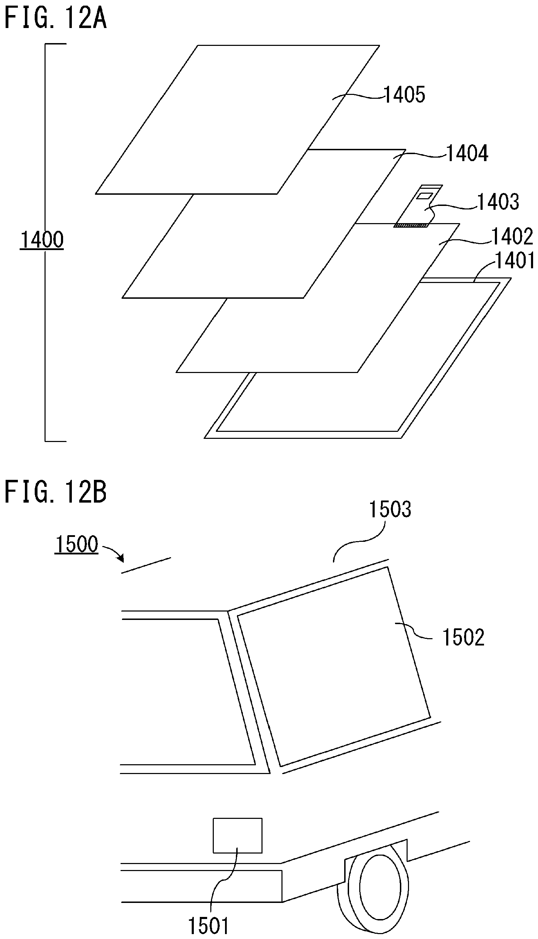

FIG. 12A illustrates next a schematic diagram depicting an example of a lighting device as a lighting apparatus having the organic light-emitting element according to the present embodiment. A lighting device 1400 may have a housing 1401, a light source 1402, a circuit board 1403, an optical film 1404 and a light-diffusing part 1405. The light source has the organic light-emitting element according to the present embodiment. The optical film may be a filter that enhances the color rendering of the light source. The light-diffusing part allows effectively diffusing light from the light source, and allows delivering light over a wide area, for instance in exterior decorative lighting. The optical filter and the light-diffusing part may be provided on the light exit side of the lighting device. A cover may be provided on the outermost part, as the case may require.

The lighting device 1400 is for instance a device for indoor illumination. The lighting device may emit white, daylight white, or other colors from blue to red. The lighting device may have a light control circuit for controlling light having the foregoing emission colors. The lighting device 1400 may have the organic light-emitting element according to the present embodiment, and a power supply circuit connected thereto. The power supply circuit is a circuit that converts AC voltage to DC voltage. White denotes herein a color with a color temperature of 4200 K, and daylight white denotes a color with a color temperature of 5000 K. The lighting device 1400 may have a color filter. The lighting device 1400 may have a heat dissipation part. The heat dissipation part dumps, out of the device, heat from inside the device; the heat dissipation part may be made up of a metal or of liquid silicone rubber, exhibiting high specific heat.

FIG. 12B is a schematic diagram of an automobile, which is an example of a mobile body having the organic light-emitting element according to the present embodiment. The automobile has tail lamps, being an example of a light fixture. The automobile 1500 may have a tail lamp 1501, of a form such that the tail lamp is lit up when for instance a braking operation is performed.

The tail lamp 1501 has the organic light-emitting element according to the present embodiment. The tail lamp may have a protective member that protects the organic light-emitting element. The protective member may be made up of any material, so long as the material has a certain degree of high strength and is transparent; the protective member is preferably made up of polycarbonate or the like. For instance a furandicarboxylic acid derivative or an acrylonitrile derivative may be mixed with the polycarbonate.

The automobile 1500 may have a vehicle body 1503, and a window 1502 attached to the vehicle body 1503. The window may be a transparent display, unless the purpose of the window is to look ahead and behind the automobile. The transparent display may have the organic light-emitting element according to the present embodiment. In that case, constituent materials such as the electrodes of the organic light-emitting element are made up of transparent members.

The mobile body having the organic light-emitting element according to the present embodiment may be for instance a vessel, an aircraft or a drone. The mobile body may have a body frame and a light fixture provided on the body frame. The light fixture may emit light for indicating the position of the body frame. The light fixture has the organic light-emitting element according to the present embodiment.

Also, the display device having the organic light-emitting element of the present embodiment can be used in a system that can be worn as a wearable device, such as smart glasses, HMDs or smart contacts. An imaging display device used in such an application example may have an imaging device capable of photoelectrically converting visible light, and a display device capable of emitting visible light.

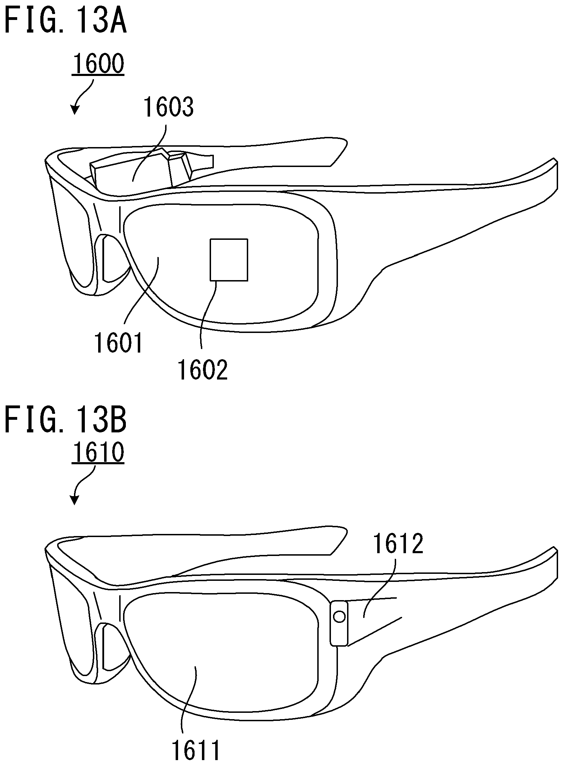

FIG. 13A illustrates spectacles 1600 (smart glasses) according to an application example of the display device having the organic light-emitting element of the present embodiment. An imaging device 1602 such as a CMOS sensor or a SPAD is provided on the front surface side of a lens 1601 of the spectacles 1600. A display device of the embodiments described above is provided on the back surface side of the lens 1601.

The spectacles 1600 further have a control device 1603. The control device 1603 functions as a power supply that supplies power to the imaging device 1602 and to the display device according to the embodiments. The control device 1603 controls the operations of the imaging device 1602 and of the display device. The lens 1601 has formed therein an optical system for condensing light onto the imaging device 1602.

FIG. 13B illustrates spectacles 1610 (smart glasses) according to another application example of the display device having the organic light-emitting element of the present embodiment. The spectacles 1610 have a control device 1612. The control device 1612 has mounted therein an imaging device corresponding to the imaging device 1602, and a display device. In a lens 1611 there is formed an optical system for projecting the light emitted by the display device in the control device 1612, such that an image is projected onto the lens 1611. The control device 1612 functions as a power supply that supplies power to the imaging device and to the display device, and controls the operations of the imaging device and of the display device. The control device may have a line-of-sight detection unit that detects the line of sight of the wearer. Infrared rays may be used herein for line-of-sight detection. An infrared light-emitting unit emits infrared light towards one eyeball of a user who is gazing at a display image. The infrared light emitted is reflected by the eyeball, and is detected by an imaging unit having a light-receiving element, whereby a captured image of the eyeball is obtained as a result. Impairment of the appearance of the image is reduced herein by having a reducing means for reducing light from the infrared light-emitting unit to the display unit, in a plan view.

The line of sight of the user with respect to the display image is detected on the basis of the captured image of the eyeball obtained through infrared light capture. Any known method can be adopted for line-of-sight detection using the captured image of the eyeball. As an example, a line-of-sight detection method can be resorted to that utilizes Purkinje images obtained through reflection of irradiation light on the cornea. More specifically, line-of-sight detection processing based on a pupillary-corneal reflection method is carried out herein. The line of sight of the user is detected by calculating a line-of-sight vector that represents the orientation (rotation angle) of the eyeball, on the basis of a Purkinje image and a pupil image included in the captured image of the eyeball, in accordance with a pupillary-corneal reflection method.

The display device having the organic light-emitting element according to the present embodiment may have an imaging device having a light-receiving element, and may control the display image of the display device on the basis of line-of-sight information about the user, from the imaging device.

Specifically, a first visual field area gazed at by the user and a second visual field area, other than the first visual field area, are determined in the display device on the basis of line-of-sight information. The first visual field area and the second visual field area may be determined by the control device of the display device; alternatively, the display device may receive visual field areas determined by an external control device. In a display area of the display device, the display resolution in the first visual field area may be controlled to be higher than the display resolution in the second visual field area. That is, the resolution in the second visual field area may set to be lower than that of the first visual field area.

The display area may have a first display area and a second display area different from the first display area, such that the display device selects the area of higher priority, from among the first display area and the second display area, on the basis of the line-of-sight information. The first display area and the second display area may be determined by the control device of the display device; alternatively, the display device may receive display areas determined by an external control device. The display device may control the resolution in a high-priority area so as to be higher than the resolution in areas other than high-priority areas. That is, the display device may lower the resolution in areas of relatively low priority.

Herein AI (Artificial Intelligence) may be used to determine the first visual field area and high-priority areas. The AI may be a model constructed to estimate, from an image of the eyeball, a line-of-sight angle, and the distance to an object lying ahead in the line of sight, using training data in the form of the image of the eyeball and the direction towards which the eyeball in the image was actually gazing at. An AI program may be provided in the display device, in the imaging device, or in an external device. In a case where an external device has the AI program, the AI program is transmitted to the display device via communication from the external device.

In a case where the display device performs display control on the basis of on visual recognition detection, the display device can be preferably used in smart glasses further having an imaging device that captures images of the exterior. The smart glasses can display captured external information in real time.

The technology of the present disclosure can provide a light emitting element of which the directivity of the emitted light is higher with the luminous efficiency enhanced by a microcavity structure.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

**Claims**

1.  A light emitting element comprising a first element having a first lower electrode, a first light emitting layer for emitting light of a first color, a charge generation layer, a second light emitting layer for emitting light of the first color, and an upper electrode in this order on a substrate,
    wherein a space between the first light emitting layer and the first lower electrode is larger than a space between the first light emitting layer and the second light emitting layer.

2.  The light emitting element according to claim 1, further comprising a second element having a second lower electrode, a third light emitting layer for emitting light of a second color different from the first color, the charge generation layer, a fourth light emitting layer for emitting light of the second color, and the upper electrode in this order on the substrate,
    wherein a space between the third light emitting layer and the second lower electrode is larger than a space between the third light emitting layer and the fourth light emitting layer.

3.  The light emitting element according to claim 1 or 2,

    wherein the following equations (1) and (2) hold;

    $$L1 = (2m - (\Phi/\pi)) \times (\lambda/4) \pm (\lambda/12) \ (m \geq 1) \cdots (1)$$

    $$L2 = (2m - (\Phi/\pi)) \times (\lambda/4) \pm (\lambda/12) \ (m \geq 2) \cdots (2)$$

    where L1 represents an optical path length between the first lower electrode and the first light emitting layer, L2 represents an optical path length between the first lower electrode and the second light emitting layer, $\lambda$ represents a main wavelength of light emitted by the first element, $\Phi$ represents a phase shift when light with the main wavelength $\lambda$ is reflected at an interface of the first lower electrode, and m is an integer.

4.  The light emitting element according to claim 2,

    wherein the first element has a reflection layer and a first optical adjustment layer between the substrate and the first lower electrode, and
    the second element has a reflection layer and a second optical adjustment layer between the substrate and the second lower electrode.

5.  The light emitting element according to any one of claims 1 to 4,

    wherein the first element has an organic layer between the first lower electrode and the charge generation layer, and an insulation layer between the first lower electrode and the organic layer,
    the insulation layer has a groove at a surface on the organic layer side, and
    the organic layer is not formed in the groove.

6.  The light emitting element according to claim 5,
    wherein the organic layer has a plurality of layers, and the thickest layer of the plurality of layers is not formed at at least a part of the groove inside.

7.  The light emitting element according to claim 6,
    wherein the first element has a reflection layer and a first optical adjustment layer between the substrate and the first lower electrode.

8.  The light emitting element according to any one of claims 1 to 4,

    wherein the first element has an insulation layer in contact with an upper surface of the first lower electrode, and at least one organic layer arranged between the charge generation layer and the upper electrode,
    the insulation layer has a groove at a surface on the organic layer side, and
    the organic layer is formed in the groove.

**9.** The light emitting element according to claim 8,
wherein the organic layer has a plurality of layers, and the thickest layer of the plurality of layers is formed at at least a part of the groove inside.

**10.** The light emitting element according to claim 9,
wherein the first element has a reflection layer and a first optical adjustment layer between the substrate and the first lower electrode.

**11.** The light emitting element according to claim 10,
wherein the organic layer is not formed in the groove.

**12.** The light emitting element according to any one of claims 1 to 11, further comprising a lens on a light emitting side of the light emitting element.

**13.** A display apparatus having a plurality of pixels,
wherein at least one of the plurality of pixels has the light emitting element according to any one of claims 1 to 12, and a transistor connected with the light emitting element.

**14.** A photoelectric conversion device comprising:

an optical part having a plurality of lenses;
an image pickup element for receiving light which has passed through the optical part; and,
a display part for displaying an image captured by the image pickup element,
wherein the display part has the light emitting element according to any one of claims 1 to 12.

**15.** Electronic equipment comprising:

a display part having the light emitting element according to any one of claims 1 to 12;
a casing provided with the display part; and
a communication part provided at the casing, and for communicating with outside.

**16.** A lighting apparatus comprising:

a light source having the light emitting element according to any one of claims 1 to 12; and
an optical diffusion part or an optical film for transmitting light emitted by the light source therethrough.

**17.** A mobile body comprising:

a light fixture having the light emitting element according to any one of claims 1 to 12; and
an airframe provided with the light fixture.

FIG. 1

EP 4 404 713 A2

FIG. 2

# FIG. 3

FIG. 4

FIG. 5

FIG. 6

411
410
409a
408
407
406
405a
403

G

413    414

FIG. 7

519a  518a  519b  518b  519c  518c

517

512

508  511  510  509a  509b  509c

507

506

503

502a  502b  502c

515a  505a  516a  514  513  515b  516b  505b  515c  516c  505c

501

500a  500b  500c

5

EP 4 404 713 A2

FIG. 8

EP 4 404 713 A2

# FIG. 9

1000

1001
1002
1003
1004
1005
1006
1007
1008
1009

FIG. 10A

FIG. 10B

FIG. 11A

1300

1301  1302

1303

FIG. 11B

1301

1314

1311

1312

1313

FIG. 12A

1405

1404

1403

1402

1401

1400

FIG. 12B

1500

1503

1502

1501

FIG. 13A

1600

1603

1601

1602

FIG. 13B

1610

1612

1611

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 20150188087